(19) **Europäisches Patentamt**
**European Patent Office**
**Office européen des brevets**

(11) **EP 2 291 665 B1**

(12) **EUROPÄISCHE PATENTSCHRIFT**

(45) Veröffentlichungstag und Bekanntmachung des Hinweises auf die Patenterteilung:
**14.12.2011 Patentblatt 2011/50**

(21) Anmeldenummer: **09765649.0**

(22) Anmeldetag: **17.06.2009**

(51) Int Cl.:
*G01R 19/20* (2006.01)   *G01R 15/18* (2006.01)

(86) Internationale Anmeldenummer:
**PCT/EP2009/004503**

(87) Internationale Veröffentlichungsnummer:
**WO 2009/153069 (23.12.2009 Gazette 2009/52)**

(54) **STROMSENSORANORDNUNG ZUR MESSUNG VON STRÖMEN IN EINEM PRIMÄRLEITER**

CURRENT SENSOR ARRAY FOR MEASURING CURRENTS IN A PRIMARY CONDUCTOR

DISPOSITIF DE DÉTECTION DE COURANT CONÇU POUR MESURER DES COURANTS DANS UN CONDUCTEUR PRIMAIRE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **20.06.2008 DE 102008029475**

(43) Veröffentlichungstag der Anmeldung:
**09.03.2011 Patentblatt 2011/10**

(73) Patentinhaber:
• **Vacuumschmelze GmbH & Co. KG**
**63450 Hanau (DE)**
• **Bosch GmbH**
**70469 Stuttgart-Feuerbach (DE)**

(72) Erfinder:
• **KOCH, Ralf**
**36399 Freiensteinau (DE)**

• **SCHOETTLE, Juergen**
**71706 Markgroeningen (DE)**
• **BREMMER, Marcus**
**71726 Benningen a. N. (DE)**
• **DOEBLITZ, Jens**
**70619 Stuttgart (DE)**
• **WOLF, Michael**
**70806 Kornwestheim (DE)**

(74) Vertreter: **Patentanwälte**
**Westphal, Mussgnug & Partner**
**Herzog-Wilhelm-Strasse 26**
**80331 München (DE)**

(56) Entgegenhaltungen:
**DE-A- 3 611 683    DE-A- 4 229 948**

**Beschreibung**

Stromsensoranordnung und Verfahren zur Messung von Strömen in einem Primärleiter.

Die Erfindung betrifft eine Stromsensoranordnung zur Messung von Strömen in einem Primärleiter über einem weiten Messbereich, insbesondere eine Stromsensoranordnung gemäß dem Oberbegriff des Anspruchs 1 sowie ein entsprechendes Strommessverfahren gemäß dem Oberbegriff des Anspruchs 7.

Gattungsgemäße Stromsensoranordnungen sind beispielsweise aus der DE 42 29 948 bekannt. Eine ähnliche Anordnung ist in der DE 36 11 683 offenbart.

Zur berührungslosen und damit potenzialfreien Messung der Stärke eines elektrischen Stromes in einem Leiter sind zum einen so genannte direktabbildende Stromsensoren bekannt, die den durch den Strom verursachten magnetischen Fluss beispielsweise mittels eines Hallsensors in einem geschlitzten magnetischen Kreis erfassen und ein der Stromstärke proportionales Signal erzeugen. Diese Sensoren sind sehr kostengünstig, weisen aber eine relativ geringe Genauigkeit auf.Direktabbildende Stromsensoren sind so genannte Open-Loop-Stromsensoren, die keinen geschlossenen Regelkreis enthalten.

Des Weiteren sind so genannte Closed-Loop-Stromsensoren bekannt, bei denen mit Hilfe eines geschlossenen Regelkreises kontinuierlich ein magnetisches Gegenfeld gleicher Größe wie das Magnetfeld des zu messenden Stromes erzeugt wird, so dass ständig eine vollständige Magnetfeldkompensation auftritt und aus den Parametern zur Erzeugung des Gegenfeldes auf die Größe des zu messenden Stromes geschlossen werden kann. Closed-Loop-Stromsensoren gehören also zur Klasse der Kompensationsstromsensoren.

Eine besondere Art von Kompensationsstromsensoren, die jedoch keinen geschlossenen Regelkreis enthalten, sind Flux-Gate-Sensoren, welche z.B. in der Druckschrift DE 42 29 948 beschrieben sind. Da bei derartigen Stromsensoren ein Hysteresefehler vermieden wird, eignen sie sich zur präzisen Strommessung in einem weiten Dynamikbereich von wenigen Milliampere bis zirka ein Kiloampere.

Flux-Gate-Sensoren ermöglichen keine kontinuierliche Strommessung, sondern das Ausgangssignal des Sensors ist ein periodisches Signal, das zu bestimmten Abtastzeiten abgetastet wird. Die Abtastwerte repräsentieren den Strom in dem Primärleiter (Primärstrom) zu den diskreten Abtastzeitpunkten.

Wenn die Frequenz des Primärstromes ähnlich oder gleich der Abtastfrequenz ist, werden im abgetasteten Ausgangssignal des Sensors aufgrund von Aliasing-Effekten Schwebungen sichtbar, die in einem Frequenzbereich liegen, der für die Strommessung wichtig ist. Diese Schwebungen stören klarerweise die Messung. Dies kann soweit gehen, dass in manchen Fällen eine sinnvolle Strommessung unmöglich wird, wodurch der praktische Anwendungsbereich des Stromsensors stark eingeschränkt ist. Des Weiteren weisen derartige Stromsensoren regelmäßig wiederkehrende Zeitintervalle auf, in denen eine Strommessung gar nicht möglich ist.

Der Erfindung liegt also die Aufgabe zugrunde, eine flexible Stromsensoranordnung zur Messung von Strömen in einem Primärleiter zur Verfügung zu stellen, bei der das oben beschriebene Problem nicht auftritt.

Die Aufgabe wird gelöst durch eine Stromsensoranordnung gemäß Patentanspruch 1 und durch ein Verfahren gemäß Anspruch 5. Weitere Beispiele der Erfindung sind Gegenstand der abhängigen Ansprüche.

Die Erfindung bezieht sich auf eine Stromsensoranordnung zur Messung eines Primärstromes in einem Primärleiter. Diese umfasst einen ferromagnetischen Kern zur magnetischen Kopplung des Primärleiters an einen Sekundärleiter; eine gesteuerte Spannungsquelle, die mit dem Sekundärleiter verbunden ist; eine mit dem Sekundärleiter verbundene Ansteuereinrichtung zum regelmäßigen Ummagnetisieren des ferromagnetischen Kerns, wobei die Ansteuereinrichtung eine gesteuerte Spannungsquelle aufweist, die mit dem Sekundärleiter verbunden und dazu ausgebildet ist eine bipolare periodische Spannung einer bestimmten Amplitude bereitzustellen, sodass ein resultierender periodischer Sekundärstrom die entsprechend einer Sensorfrequenz periodische Ummagnetisierung des ferromagnetischen Kerns bewirkt; und eine Steuereinrichtung zur Steuerung der Spannungsquelle, wobei die Steuereinrichtung dazu ausgebildet ist, die Sensorfrequenz während des Betriebes der Stromsensoranordnung zu variieren.

Die Erfindung bezieht sich auch auf ein Verfahren zur Messung eines Primärstromes in einem Primärleiter, der über einen ferromagnetischen Kern magnetisch mit einem Sekundärleiter gekoppelt ist. Das Verfahren umfasst folgende Schritte: Anlegen einer Spannung einer bestimmten Amplitude an den Sekundärleiter, sodass ein Sekundärstrom zur Ummagnetisierung des ferromagnetischen Kerns fließt; Messen des Sekundärstromes während des Ummagnetisierens des Kerns um einen ersten Messwert zu erhalten; Umpolen der Spannung, sodass ein Sekundärstrom zur erneuten Ummagnetisierung des ferromagnetischen Kerns fließt; und Messen des Sekundärstromes während des Ummagnetisierens des Kerns um einen zweiten Messwert zu erhalten; Berechnen des Primärstromes in Abhängigkeit des ersten und des zweiten Messwertes, wobei das Umpolen der Spannung regelmäßig mit einer bestimmten Sensorfrequenz erfolgt und die Sensorfrequenz laufend variiert wird.

Dabei kann die Spannungsamplitude der Spannung variiert werden, dass die Frequenz des Sekundärstroms entsprechend variiert wird. Bei dem sogenannten Teilhytereseverfahren kann über den Zeitpunkt des Umpolens der Spannung der Magnetisierungshub beim Umpolen variiert werden, wodurch ebenfalls die Frequenz des Sekundärstroms variiert wird. In diesem Fall wird der Kern nicht vollständig ummagnetisiert.

Die Erfindung wird nachfolgend anhand von Figuren näher erläutert, wobei gleiche Bezugszeichen gleiche Komponenten bzw. gleiche Signale bezeichnen. Es zeigt:

Figur 1 ein Blockschaltbild eines Beispiels der erfinderischen Stromsensoranordnung;

Figur 2 den Signalverlauf des Sekundärstroms, der Magnetisierung und der magnetischen Feldstärke bei einer freischwingenden Stromsensoranordnung mit einem Primärstrom von null;

Figur 3 den Signalverlauf des Sekundärstroms, der Magnetisierung und der magnetischen Feldstärke bei einer freischwingenden Stromsensoranordnung mit einem Primärstrom größer null;

Figur 4 den bei dem Stromsensor möglichen Aliasingeffekt (a) und "blinde" Zeitintervalle des Sensors (b) anhand der Signalverläufe von Primär- und Sekundärstrom;

Figur 5 den Signalverlauf des Sekundärstroms, der Magnetisierung und der magnetischen Feldstärke bei einer Stromsensoranordnung im Teilhysteresebetrieb mit einem Primärstrom von null und

Figur 6 das Ausführungsbeispiel nach Figur 1 im Detail.

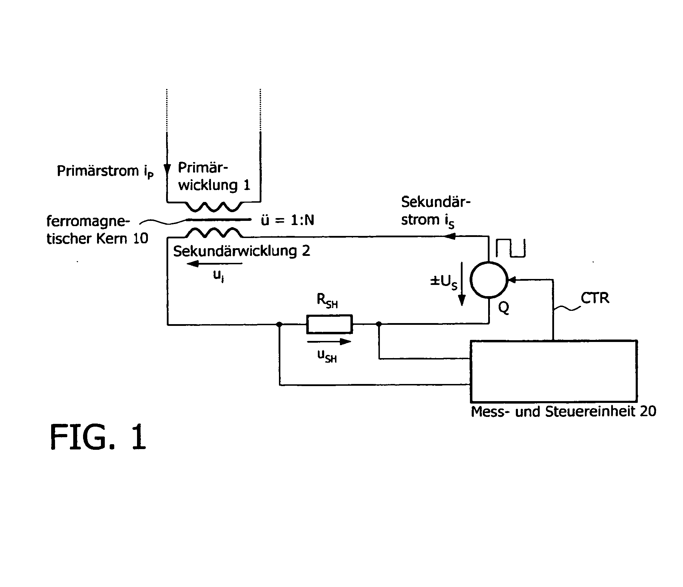

In Figur 1 ist anhand eines Blockschaltbildes der prinzipielle Aufbau eines Kompensationsstromsensors ohne Hysteresefehler dargestellt. Der zu messende Strom (Primärstrom ip) fließt durch eine Primärwicklung 1, die über einen weichmagnetischen und beispielsweise ungeschlitzten Kern 10 magnetisch an eine Sekundärwicklung 2 (Windungszahl N) gekoppelt ist. Die Primärwicklung 1 kann z. B. aus einer einzigen Windung bestehen, d.h. die Primärwicklung 1 wird aus einem Leiter gebildet, der durch den Kern 10 hindurchgeführt ist (Windungszahl 1). Die Sekundärwicklung 2 ist in Serie zu einer gesteuerten Spannungsquelle Q geschalten, die den Sekundärstrom $i_s$ durch die Sekundärwicklung erzeugt. Zur Messung des Sekundärstromes $i_s$ ist zwischen Sekundärwicklung 2 und Spannungsquelle Q ein Shunt-Widerstand $R_{SH}$ geschaltet. Die Spannung $U_{SH}$ über dem Shunt-Widerstand $R_{SH}$ ist einer Mess- und Steuereinheit 20 zugeführt, die auch ein Steuersignal CTR zur Ansteuerung der gesteuerten Spannungsquelle Q bereitstellt.

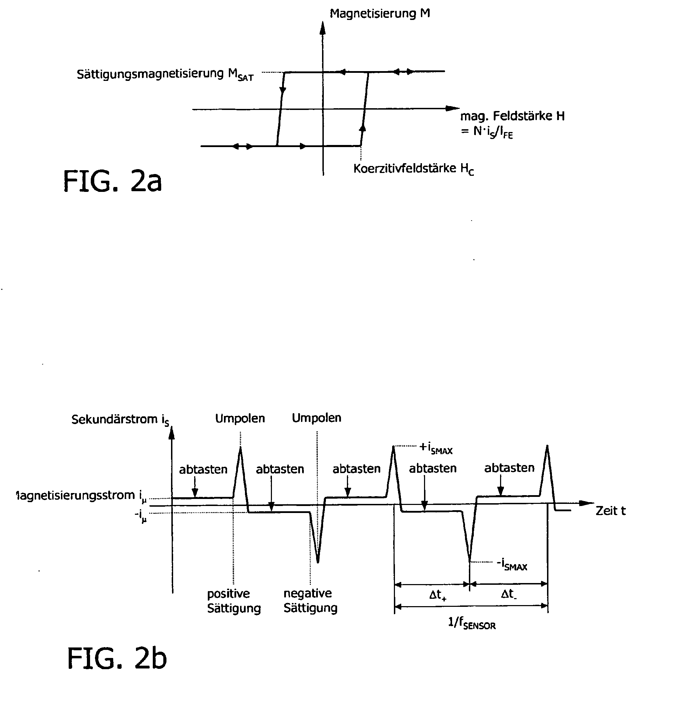

Die Funktionsweise der in Figur 1 dargestellten Strommessanordnung wird im Folgenden anhand der Figuren 2 bis 4 beschrieben. Figur 2a beschreibt die ferromagnetischen Eigenschaften des weichmagnetischen Kerns 10 anhand einer Magnetisierungskennlinie, wobei auf der Abszisse die magnetische Feldstärke H und auf der Ordinate die Magnetisierung M aufgetragen sind. Die Magnetisierungskennlinie weist eine annähernd rechteckförmige Hysterese auf mit einer bestimmten Koerzitivfeldstärke $H_c$ und einer bestimmten Sättigungsmagnetisierung $M_{SAT}$. Für die magnetische Feldstärke H gilt entsprechend dem Ampère'schen Gesetz vereinfacht $H = N \cdot i_s / l_{FE}$, wobei der Parameter $1_{FE}$ die magnetische Weglänge der Magnetfeldlinien im Kern 10 bezeichnet.

Für die in der Sekundärspule 2 induzierte Spannung $u_i$ gilt entsprechend dem Farady'schen Gesetz

$$u_i = -N \cdot d\Phi/dt = -N \cdot A \cdot dB/dt, \qquad (1)$$

wobei der Parameter A die Querschnittsfläche des Kerns 10, das Symbol Φ den von dem Sekundärstrom $i_s$ verursachten magnetischen Fluss durch den Kern 10 und das Symbol B die magnetische Flussdichte bezeichnet. Die magnetische Flussdichte B lässt sich allgemein durch die Beziehung $B = \mu_0 \cdot (H+M)$ darstellen; daraus folgt, dass während des Ummagnetisierens des Kerns 10 (entspricht dem linken oder rechten vertikalen Ast der Magnetisierungskennlinie in Figur 2a) die Änderungsrate der Magnetisierung dM/dt proportional zu der induzierten Spannung $u_i$ ist und dabei die magnetische Feldstärke H und somit auch der Sekundärstrom $i_s$ konstant sind, d.h.

$$u_i = -N \cdot A \cdot \mu_0 \cdot dM/dt \qquad \text{(beim Ummagnetisieren)} \qquad (2)$$

Man kann auch sagen die differentielle Induktivität der Sekundärspule 2 ist während des Ummagnetisierens nahezu unendlich groß. Sobald die Magnetisierung im Kern 10 die Sättigungsmagnetisierung $M_{SAT}$ erreicht hat, steigt der Sekundärstrom $i_s$ an, und wird nur mehr durch den ohmschen Widerstand der Sekundärwicklung 2 und den Shunt-Widerstand $R_{SH}$ begrenzt.

Das Ansteigen des Sekundärstroms $i_s$ wird von der Mess- und Steuereinheit 20 beispielsweise mit Hilfe von Komparatoren erkannt (vgl. Figur 2b). Sobald der Sekundärstrom einen positiven Schwellwert $+i_{SMAx}$ überschreitet oder einen negativen Schwellwert $-i_{SMAX}$ unterschreitet erzeugt die Mess- und Steuereinheit 20 ein entsprechendes Steuersignal CTR um die Spannungsquelle Q umzupolen und den nächsten Ummagnetisierungszyklus einzuleiten.

Der zeitliche Verlauf des Sekundärstromes bei einem Primärstrom $i_P$ von null ist in Figur 2b dargestellt. Während des Ummagnetisierens (vgl. annähernd vertikale Äste der Magnetisierungskennlinie aus Figur 2a) ist der Sekundärstrom konstant und entspricht dem Magnetisierungsstrom $+i_\mu$ bzw. $-i_\mu$. Der Betrag des Magnetisierungsstrom $i_\mu$ hängt von der Breite der Hysterese in der Magnetisierungskennlinie, also von der Koerzitivfeldstärke $H_C$, ab, d.h. $i_\mu = 1_{FE}/N \cdot H_C$. Sobald die Magnetisierung im Kern 10 die positive oder negative Sättigungsmagnetisierung erreicht beginnt der Sekundärstrom $i_s$ anzusteigen, wie oben bereits beschrieben. Aufgrund der Symmetrie der Hysteresekennlinie ist der zeitliche Verlauf des Sekundärstroms $i_s$ auch symmetrisch um einen mittleren Stromwert.

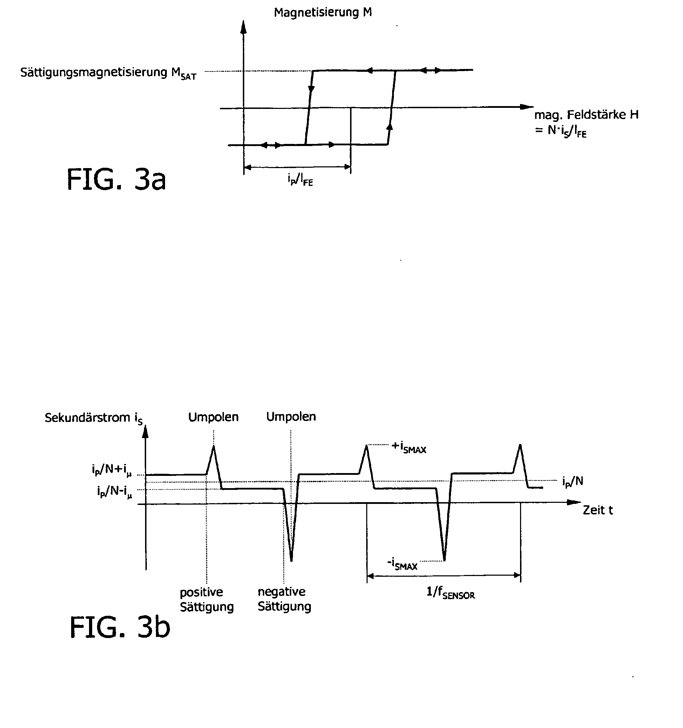

Die Figuren 3a und 3b zeigen den gleichen Sachverhalt wie die Figuren 2a und 2b, jedoch für einen Primärstrom $i_P$ ungleich null. Das von dem Primärstrom $i_P$ erzeugte Magnetfeld überlagert sich in dem weichmagnetischen Kern 10 additiv dem Magnetfeld des Sekundärstromes $i_s$, was als Verschiebung der Magnetisierungskennlinie entlang der Abszisse dargestellt werden kann. Dieser Sachverhalt ist in Figur 3a bildlich dargestellt. Der korrespondierende zeitliche Verlauf des Sekundärstromes ist in Figur 3b dargestellt. Dieser ist ähnlich wie in Figur 2b bei einem Primärstrom von null mit dem Unterschied, dass der Sekundärstrom nicht mehr symmetrisch um die Abszisse ($i_S$=0) verläuft, sondern symmetrisch um die horizontale Gerade ($i_S = i_P/N$). Das heißt während des Ummagnetisierens stehen Primärstrom und Sekundärstrom im selben Verhältnis ü=1:N wie die Wicklungszahlen von Primärwicklung 1 und Sekundärwicklung 2, mit Ausnahme des Hysterese-Offsets in der Höhe des Magnetisierungsstroms $i_\mu$. Zur Strommessung wird das Sekundärstromsignal $i_s$, genau genommen das Spannungssignal $\mu_{SH}$ am Shunt-Widerstand $R_{SH}$, während des Ummagnetisierungsvorganges abgetastet. So erhält man in der ersten Hälfte einer Periode des Sekundärstromes einen Strommesswert $i_S[n-1]=(i_P/N)+i_\mu$ und in der zweiten Periodenhälfte einen Strommesswert $i_S[n]=(i_P/N)-i_\mu$. Durch Mittelwertbildung lässt sich der Hysteresefehler, der durch den Magnetisierungsstrom verursacht wird eliminieren, der Primärstrom zu einem Abtastzeitpunkt n berechnet sich wie folgt:

$$i_P[n]= N \cdot (i_S[n-1]+i_S[n])/2. \qquad\qquad (3)$$

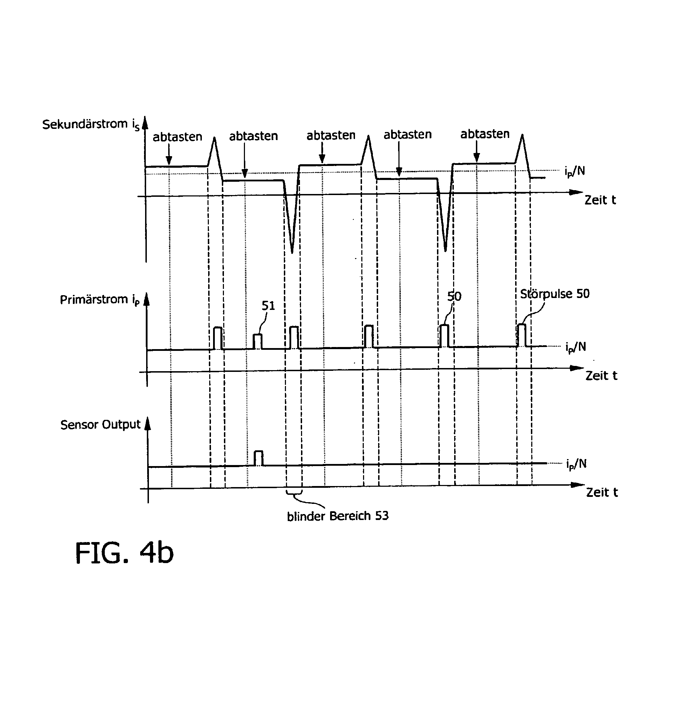

Dadurch dass die Hysterese der Magnetisierungskennlinie auf das Messergebnis keinen Einfluss hat, eignet sich dieses Strommessverfahren sehr gut zur Messung sehr kleiner Ströme. Der Messbereich reicht von einigen Milliampere bis hin zu einem Kiloampere. Während des Ummagnetisierungsvorganges im Kern 10 folgt der Sekundärstrom $i_s$ dem Primärstrom $i_P$ entsprechend dem Übertragungsverhältnis 1:ü. Der Sekundärstrom wird währenddessen zumindest einmal abgetastet um einen Messwert ($i_S+i_\mu$ bzw. $i_S-i_\mu$) zur Berechnung des Primärstromes zu erhalten. Während des Ummagnetisierens kann die Abtastung aber auch wiederholt mit einer Abtastrate erfolgen, die wesentlich höher ist, als die Schwingfrequenz des Sensors selbst, beispielsweise mit Abtastfrequenzen zwischen 1 kHz und 1 MHz. So ist es möglich auch transiente Vorgänge im Primärstromsignal $i_P$ zu erfassen, solange diese transienten Vorgänge während des Ummagnetisierens auftreten. Während der Kern 10 in magnetischer Sättigung ist, ist keine sinnvolle Strommessung möglich. Diese Problematik wird später anhand von Figur 4b noch genauer beschrieben.

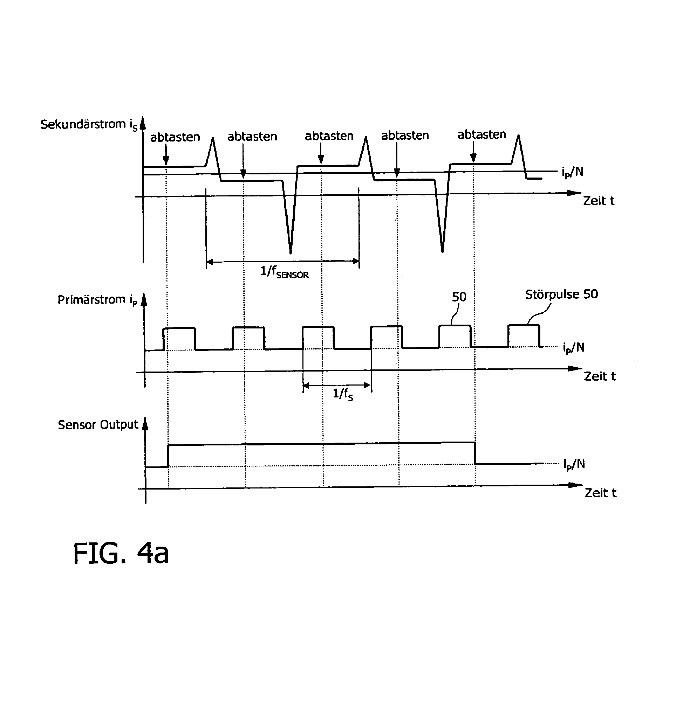

Aufgrund der Tatsache, dass die oben beschriebene Stromsensoranordnung keine kontinuierliche Messung erlaubt sondern den Sekundärstrom nur zu diskreten Zeitpunkten abgetastet wird, können unerwünschte Aliasing-Effekte auftreten, die sich im Messergebnis vor allem als niederfrequente Schwebungen manifestieren. Die Abtastung kann beispielsweise immer eine feste Zeit nach dem Umpolen der Spannung $U_S$ der Stromquelle Q ausgelöst werden, wobei die Zeit so kurz gewählt werden kann, dass der Sekundärstrom $i_s$ eingeschwungen ist, d.h. dem Primärstrom ip folgt. Die erwähnte Aliasing-Problematik ist beispielhaft in Figur 4a dargestellt.

Ist die Frequenz des Primärstromes $i_P$ gleich oder zumindest ähnlich groß wie die Schwingfrequenz der Sensoranordnung, d.h. des Sekundärstromes $i_s$, oder wie ein ganzzahliges Vielfaches davon, dann können unerwünschte Schwebungen das Messsignal überlagern, sodass keine vernünftige Messung möglich ist. Im vorliegenden Fall ist der Primärstrom $i_P$ mit einem Rechtecksignal moduliert, dessen Frequenz in einer ähnlichen Größenordnung liegt, wie die doppelte Schwingfrequenz $f_{SENSOR}$ des Stromsensors, d.h. nahe der Abtastfrequenz. In diesem Fall kommt es zu Aliasing-Effekten, die sich als niederfrequente Schwebungen in einem Frequenzbereich auswirken, der für die Messung wichtig ist.

In dem in der Figur 4a gezeigten Beispiel sind dem Primärstrom $i_P$ Störimpulse 50 mit überlagert, die sich mit einer Frequenz $f_S$ wiederholen. Die Frequenz $f_S$ der Störimpulse 50 liegt in einer ähnlichen Größenordnung wie die doppelte Sensorschwingfrequenz $f_{SENSOR}$. Der Unterschied zwischen $f_S$ und $2f_{SENSOR}$ ist gerade so groß, dass sich eine Schwebung mit einer Schwebungsfrequenz von rund der halben Sensorfrequenz ergibt. Wäre der Unterschied geringer, ist die Schwebungsfrequenz klarerweise och geringer.

Anhand der Figur 4b wird ein weiteres Problem von herkömmlichen Flux-Gate Sensoren illustriert. Während des Ummagnetisierens des Kerns folgt (vgl. Figuren 2 und 3) der Sekundärstrom $i_s$ dem Primärstrom ip entsprechend dem Übertragungsverhältnis 1:ü und es ist eine quasi kontinuierliche Strommessung möglich. Im Gegensatz dazu ist im Bereich magnetischer Sättigung des Kerns 10 keine sinnvolle Messung möglich, der Sensor ist also während bestimmter Zeitintervalle 53, in denen sich der Kern in magnetischer Sättigung befindet, praktisch "blind". Diese Zeitintervalle 53 treten periodisch mit der doppelten Schwingfrequenz $f_{SENSOR}$ des Stromsensors auf, was zur Folge hat, dass impulsförmige Stromanteile 50, die innerhalb des Zeitintervalls 53 auftreten, vom Sensor gar nicht erkannt werden, auch wenn diese Stromimpulse 50 periodisch auftreten. Stromimpulse 51, die während des Ummagnetisierens des Kerns 10 auftreten, können ohne weiteres vom Sensor erfasst werden, wenn die Abtastung des Sekundärstroms $i_s$ mit einer Abtastfrequenz erfolgt, die groß genug ist, um den Stromimpuls 51 aufzulösen.

Aus G1. (2) ist erkennbar, dass die Geschwindigkeit des Ummagnetisierungsvorganges umso höher ist, je höher die Amplitude $U_S$ der von der Spannungsquelle Q erzeugten Spannung ist, denn aus G1. (2) folgt:

$$dM/dt \; = \; -u_i/(N \cdot A \cdot \mu_0) \; = \; -(U_S - R_{SH} \cdot i_S)/(N \cdot A \cdot \mu_0). \qquad (4)$$

Folglich ist die Schwingfrequenz des Sekundärstromes umso höher, je höher die Amplitude $U_S$ der von der Spannungsquelle Q erzeugten Spannung ist. Die Schwingfrequenz $F_{SENSOR}$ des Sensors folgt aus Gl. (4):

$$f_{SENSOR} \; = \; 1/(\Delta t_+ + \Delta t_-), \qquad (5a)$$

wobei

$$\Delta t_+ \; = \; (\mu_0 \cdot \Delta M \cdot N \cdot A)/(U_S - i_P \cdot R_{SH}/N) \qquad (5b)$$

$$\Delta t_- \; = \; (\mu_0 \cdot \Delta M \cdot N \cdot A)/(U_S + i_P \cdot R_{SH}/N). \qquad (5c)$$

Der Parameter $\Delta M$ ist dabei der Magnetisierungshub während eines Ummagnetisierungsvorganges. Aus den G1. (5a) bis (5c) ist erkennbar, dass die Schwingfrequenz $f_{SENSOR}$ des Sensors einerseits von dem Primärstrom selbst, als auch von der Spannungsamplitude $U_S$ der von der Spannungsquelle Q erzeugten Spannung und von dem Magnetisierungshub $\Delta M$ abhängt.

Wenn in einem konkreten Anwendungsfall die Signalfrequenz des Primärstromes $i_P$ ähnlich oder gleich groß ist wie die Schwingfrequenz $f_{SENSOR}$ des Sensors oder ein Vielfaches davon, dann kann, um den in Figur 4a beschriebenen unerwünschten Aliasingeffekt zu vermeiden, die Schwingfrequenz $f_{SENSOR}$ durch eine Veränderung der Spannungsamplitude $U_S$ oder des Magnetisierungshubes $\Delta M$ entsprechend angepasst werden, um unerwünschte Effekte zu vermeiden. Dadurch werden auch die Zeitintervalle 53, in denen keine sinnvolle Strommessung möglich ist (vgl. Figur 4b), verschoben, sodass periodisch auftretende Impulse 50 nicht dauerhaft vom Sensor "übersehen" werden.

Bei einer freischwingenden Stromsensoranordnung, deren Sekundärstromverlauf in Figur 2 gezeigt ist, ist der Magnetisierungshub $\Delta M$ durch die Sättigungsmagnetisierung $M_{SAT}$ vorgegeben ($\Delta M = 2 \cdot M_{SAT}$), sodass eine Variation der Schwingfrequenz $F_{SENSOR}$ in einfacher Weise über eine Variation der Spannungsamplitude $U_S$ der Stromquelle Q erfolgen kann. Die Spannungsamplitude wird beispielsweise über ein Steuersignal von der Mess- und Steuereinheit 20 so angesteuert, dass die Schwingfrequenz $F_{SENSOR}$ der Stromsensoranordnung während des Betriebes laufend variiert. So kann erreicht werden, dass eine Störung 50 mit einer bestimmten Frequenz im abgetasteten Sensorsignal (Messsignal) nicht mehr als Schwebung erscheint. Stattdessen sind im Messsignal nur mehr unregelmäßige Störpulse zu sehen, die jedoch die Messung - im Gegensatz zu der Schwebung - nicht ernsthaft beeinträchtigen.

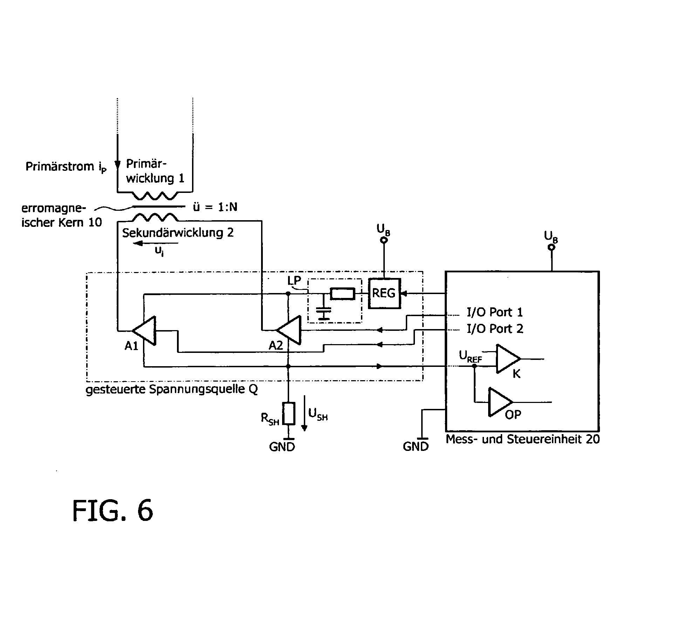

Das Variieren bzw. Anpassen der Sensorfrequenz $F_{SENSOR}$ wird von der Mess- und Steuereinheit 20 gesteuert (vgl. Figuren 1 und 6). Die Mess- und Steuereinheit 20 kann beispielsweise dazu ausgebildet sein, die Sensorfrequenz $f_{SENSOR}$ stochastisch zu variieren. Alternativ kann die Sensorfrequenz $f_{SENSOR}$ auch nach einem bestimmten, vorgegebenen Frequenzmuster variiert werden. Dies kann beispielsweise dadurch erreicht werden, indem die Steuereinrichtung die Amplitude der Spannungsquelle Q (siehe Figur 1) amplitudenmoduliert, wodurch die Sensorfrequenz $f_{SENSOR}$ frequenzmoduliert wird. Generell kann durch eine Veränderung der Spannungsamplitude der Spannungsquelle Q die Sensorfrequenz in einem gewissen Bereich verändert werden (vgl. Gleichungen 5a-c). Ist die Frequenz $f_S$ einer Störung 50 (vgl. Figur 4a) bekannt kann es sinnvoll sein, die Mess- und Steuereinheit 20 so auszugestalten, dass die Sensorfrequenz $F_{SENSOR}$ oder ein ganzzahliges Vielfaches davon sich so stark von der Frequenz $f_S$ der Störung 50 unterscheidet, dass die resultierende Schwebung in einem Frequenzbereich auftritt, der für die Messung nicht relevant ist, beispielsweise in einem Frequenzbereich oberhalb des für die Messung interessierenden Frequenzbereiches.

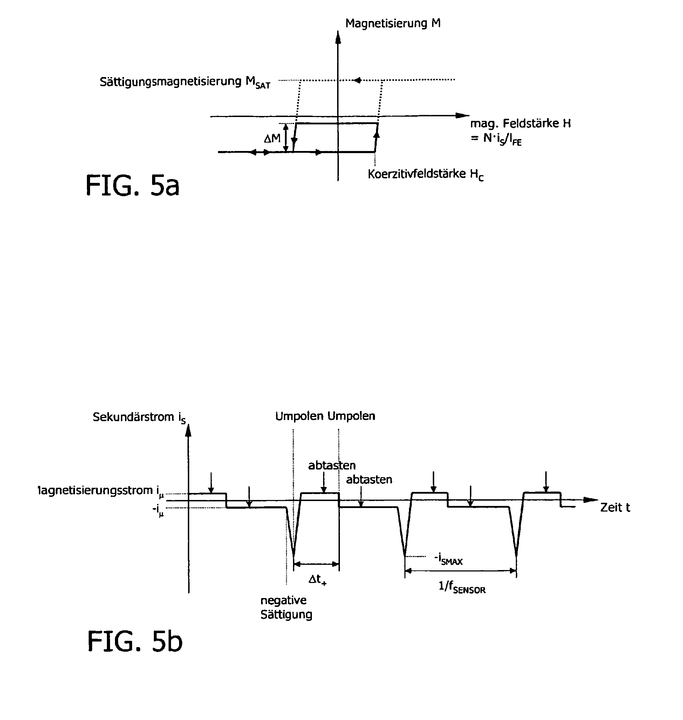

Wie oben bereits angedeutet kann die Schwingfrequenz $f_{SENSOR}$ des Sensors auch durch eine Veränderung des Magnetisierungshubes $\Delta M$ angepasst werden. In diesem Fall darf die Stromsensoranordnung nicht mehr frei schwingen und zumindest der Ummagnetisierungsvorgang in einer Richtung muss zeitgesteuert erfolgen. Daraus folgt, dass nicht mehr die gesamte Hysterese der Magnetisierungskennlinie durchlaufen wird (vgl. Figuren 2a und 3a), sondern nur ein Teil der Hysterese, beispielsweise 20 bis 30 Prozent. Dieser Fall (Teilhysteresemethode) ist in den Figuren 5a und 5b dargestellt.

Bei der Teilhysteresemethode ist zumindest der Teil $\Delta t_+$ oder alternativ $\Delta t$-der Periodendauer $f_{SENSOR}^{-1}$ der Sensorschwingfrequenz vorgegeben, d.h. die Spannungsquelle Q wird nach einer bestimmten Zeit $\Delta t_+$ umgepolt, bevor der Kern 10 sein Sättigungsmagnetisierung $M_{SAT}$ erreicht. Daraufhin wird der weichmagnetische Kern 10 wieder bis zur Sättigungsmagnetisierung - $M_{SAT}$ ummagnetisiert und der Zyklus beginnt von vorne. Im Prinzip könnte auch das Ummagnetisieren in beide Richtungen zeitgesteuert erfolgen, dann kann es jedoch passieren, dass der tatsächlich durchlaufene Teil der Hysteresekurve aufgrund von unvermeidbaren Ungenauigkeiten innerhalb der gesamten Hysteresekurve "driftet". Um immer von einem bestimmten Referenzpunkt der Hysteresekurve die Ummagnetisierung zu starten, kann zumindest jeder zweite Ummagnetisierungsvorgang (wie in dem Beispiel aus Figur 3) komparatorgesteuert erfolgen, nachdem der Kern bis in die Sättigung magnetisiert wurde.

Im übrigen funktioniert ein Sensor, der nach der Teilhysteresemethode arbeitet, gleich wie bereits anhand der Figuren 2 und 3 beschrieben. Der einzige Unterschied besteht darin, dass nur die Ummagnetisierung in eine Richtung durch einen Komparator gesteuert erfolgt, wie bei der Methode aus Figur 2, die Ummagnetisierung in die andere Richtung erfolgt zeitgesteuert durch eine Vorgabe der Zeitspanne $\Delta t_+$ bzw. $\Delta t$-, wodurch der Magnetisierungshub $\Delta M$ entsprechend der G1. (5b) eingestellt wird.

Analog zu dem oben beschriebenen Fall, bei dem eine Anpassung der Spannungsamplitude $U_S$ erfolgt, kann bei der Teilhysteresemethode der Magnetisierungshub $\Delta M$ über die Zeitspanne $\Delta t_+$ (bzw. $\Delta t_-$) beispielsweise über ein Steuersignal CTR von der Mess- und Steuereinheit 20 so angepasst werden, dass die Schwingfrequenz $f_{SENSOR}$ der Stromsensoranordnung während des Betriebes ständig variiert wird. Auch in diesem Fall kann die Variation der Sensorfrequenz $F_{SENSOR}$ über eine Variation des Magnetisierungshubes $\Delta M$ bzw. des Zeitpunktes des Umpolens der Spannungsquelle Q zufällig oder nach einem bestimmten Frequenzmuster erfolgen.

Analog zu der oben beschriebenen Amplitudenmodulation der Spannung $U_S$ der Stromquelle Q kann bei der Teilhysteresemethode der Magnetisierungshub $\Delta M$ über eine Modulation der Zeitspanne $\Delta t_+$ bzw. $\Delta t_-$ moduliert werden. Um eine Frequenzmodulation der Sensorfrequenz $f_{SENSOR}$ zu erreichen kann der Zeitpunkt des Umpolens der Spannungsquelle Q um einen Mittelwert moduliert werden. Ist die Frequenz $f_S$ einer Störung 50 (vgl. Figur 4a) bekannt, kann die Sensorfrequenz $f_{SENSOR}$ so eingestellt werden, dass sie oder ein ganzzahliges Vielfaches davon sich so stark von der Frequenz $f_S$ der Störung 50 unterscheidet, dass die resultierende Schwebung in einem Frequenzbereich auftritt, der für die Messung nicht relevant ist.

Figur 6 zeigt ein Beispiel einer praktischen Implementierung der Sensoranordnung aus FIG. 1. Die Spannungsquelle Q wird aus zwei Gegentaktendstufen A1 und A2 mit niederohmigen Ausgangswiderstand gebildet, die über einen Spannungsregler REG versorgt werden. An den Ausgängen der beiden Endstufen A1 und A2 ist jeweils ein Anschluss der Sekundärwicklung 2 verbunden. Der Shunt-Widerstand $R_{SH}$ ist in den Versorgungsstrompfad der Endstufen geschaltet, im vorliegenden Fall ist ein Anschluss des Shunt-Widerstandes $R_{SH}$ mit dem Massepotential verbunden um ein massebezogenes Stromsignal $U_{SH}$ zu erhalten. Das Stromsignal $U_{SH}$, d.h. die über dem Shunt-Widerstandes $R_{SH}$ abfallende Spannung ist der Mess- und Steuereinheit 20 zugeführt. Die Eingänge der Gegentaktendstufen sind mit je einem I/O Port der Mess- und Steuereinheit 20 verbunden und werden immer gegensinnig angesteuert. In den Versorgungsstrompfad der Endstufen kann optional ein Tiefpass LP geschaltet sein, um die maximale Änderungsrate des Sekundärstromes $i_S$ zu begrenzen. Die Mess- und Steuereinheit 20 umfasst auch einen Verstärker OP zum Verstärken des Strommesssignals $U_{SH}$. Dieses Signal wird beispielsweise bearbeitet oder unbearbeitet einem Analog-Digital-Converter (ADC) zugeführt, um einen digitalen Messwert zu erhalten. Zum Bestimmen des Zeitpunktes einer Ummagnetisierung des weichmagnetischen Kerns 10 kann die Mess-und Steuereinheit 20 auch einen Komparator K aufweisen, der das Strommesssignal $U_{SH}$ mit einem Referenzsignal $U_{REF}$ vergleicht, das den maximalen Sekundärstromwert $i_{SMAx}$ repräsentiert.

**Patentansprüche**

1.  Stromsensoranordnung zur Messung eines Primärstromes ($I_1$) in einem Primärleiter, die aufweist:

einen ferromagnetischen Kern zur magnetischen Kopplung des Primärleiters an einen Sekundärleiter;
eine gesteuerte Spannungsquelle (G), die mit dem Sekundärleiter verbunden ist;
eine mit dem Sekundärleiter verbundene Ansteuereinrichtung zum regelmäßigen Ummagnetisieren des ferromagnetischen Kerns, wobei
die Ansteuereinrichtung eine gesteuerte Spannungsquelle (G) aufweist, die mit dem Sekundärleiter verbunden und dazu ausgebildet ist, eine bipolare periodische Spannung ($\pm$U) einer bestimmten Amplitude bereitzustellen, sodass ein resultierender periodischer Sekundärstrom ($I_2$) die entsprechend einer Sensorfrequenz periodische Ummagnetisierung des ferromagnetischen Kerns bewirkt, und eine Steuereinrichtung zur Steuerung der Spannungsquelle,
**dadurch gekennzeichnet, dass** die Steuereinrichtung dazu ausgebildet ist, die Sensorfrequenz während des Betriebes der Stromsensoranordnung zu variieren.

2. Stromsensoranordnung nach Anspruch 1, bei der die Steuereinrichtung dazu ausgebildet ist, die Sensorfrequenz stochastisch zu variieren.

3. Stromsensoranordnung nach Anspruch 1, bei der die Steuereinrichtung dazu ausgebildet ist, die Sensorfrequenz nach einem bestimmten Frequenzmuster zu variieren.

4. Stromsensoranordnung nach Anspruch 1, bei der
der Primärstrom Signalanteile einer bestimmten Signalfrequenz aufweist und bei der
die Steuereinrichtung dazu ausgebildet ist, die Sensorfrequenz in Abhängigkeit von der Signalfrequenz so zu variieren, dass sich die Sensorfrequenz oder ein ganzzahliges Vielfaches davon von der Signalfrequenz unterscheidet.

5. Stromsensoranordnung nach einem der Ansprüche 1 bis 4, bei der die Steuereinrichtung dazu ausgebildet ist, die Spannungsamplitude der Spannungsquelle zu variieren, wodurch die Sensorfrequenz variiert wird.

6. Stromsensoranordnung nach einem der Ansprüche 1 bis 5, bei der die Steuereinrichtung dazu ausgebildet ist, den Zeitpunkt des Umpolens der Spannungsquelle zu variieren, wodurch die Sensorfrequenz variiert wird.

7. Verfahren zur Messung eines Primärstromes in einem Primärleiter, der über einen ferromagnetischen Kern magnetisch mit einem Sekundärleiter gekoppelt ist, mit den folgenden Schritten:

Anlegen einer Spannung einer bestimmten Amplitude an den Sekundärleiter, sodass ein Sekundärstrom zur Ummagnetisierung des ferromagnetischen Kerns fließt;
Messen des Sekundärstromes während des Ummagnetisierens des Kerns um einen ersten Messwert zu erhalten;
Umpolen der Spannung, sodass ein Sekundärstrom zur erneuten Ummagnetisierung des ferromagnetischen Kerns fließt;
Messen des Sekundärstromes während des Ummagnetisierens des Kerns um einen zweiten Messwert zu erhalten;
Berechnen des Primärstromes in Abhängigkeit des ersten und des zweiten Messwertes,
**dadurch gekennzeichnet, dass**
das umpolen der Spannung regelmäßig mit einer bestimmten Sensorfrequenz erfolgt und die Sensorfrequenz laufend variiert wird.

8. Verfahren nach Anspruch 7, bei dem die Sensorfrequenz stochastisch variiert wird.

9. Verfahren nach Anspruch 7, bei dem die Sensorfrequenz nach einem bestimmten Frequenzmuster variiert wird.

10. Verfahren nach Anspruch 7, bei dem
der Primärstrom Signalanteile einer bestimmten Signalfrequenz aufweist und bei dem
die Sensorfrequenz in Abhängigkeit von der Signalfrequenz so variiert wird, dass sich die Sensorfrequenz oder ein ganzzahliges Vielfaches davon von der Signalfrequenz unterscheidet.

11. Verfahren nach einem der Ansprüche 7 bis 10, bei dem die Amplitude der Spannung variiert wird, wodurch die Sensorfrequenz variiert wird.

12. Verfahren nach Anspruch 11, bei dem die Amplitude der Spannung amplitudenmoduliert wird, sodass die Sensorfrequenz frequenzmoduliert ist.

**13.** Verfahren nach einem der Ansprüche 7 bis 12, bei dem der Zeitpunkt des Umpolens der Spannung variiert wird, wodurch die Sensorfrequenz verändert wird.

**14.** Verfahren nach Anspruch 13, bei dem der Zeitpunkt des Umpolens der Spannung periodisch um einen mittleren Wert moduliert wird.

**Claims**

**1.** A current sensor assembly for measuring a primary current ($I_1$) in a primary conductor, which includes:

> a ferromagnetic core for magnetically coupling the primary conductor to a secondary conductor;
> a controlled voltage source (G), which is connected to the secondary conductor;
> an activation device, which is connected to the secondary conductor, for the regular reversal of the magnetization of the ferromagnetic core, wherein
> the control device includes a controlled voltage source (G), which is connected to the secondary conductor and is constructed to provide a bipolar periodic voltage ($\pm U$) of a predetermined amplitude so that a resulting periodic secondary current ($I_2$) effects the periodic demagnetization of the ferromagnetic core corresponding to a sensor frequency and a control device for controlling the voltage source, **characterised in that** the control device is constructed to vary the sensor frequency during the operation of the current sensor assembly.

**2.** A current sensor assembly as claimed in Claim 1, in which the control device is constructed to vary the sensor frequency stochastically.

**3.** A current sensor assembly as claimed in Claim 1, in which the control device is constructed to vary the sensor frequency in accordance with a predetermined frequency pattern.

**4.** A current sensor assembly as claimed in Claim 1, in which the primary current includes signal components of a predetermined signal frequency and in which the control device is constructed to vary the sensor frequency in dependence on the signal frequency so that the sensor frequency or a whole number multiple thereof differs from the signal frequency.

**5.** A current sensor assembly as claimed in one of Claims 1 to 4, in which the control device is constructed to vary the voltage amplitude of the voltage source, whereby the sensor frequency is varied.

**6.** A current sensor assembly as claimed in one of Claims 1 to 5, in which the control device is constructed to vary the time of the polarity reversal of the voltage source, whereby the sensor frequency is varied.

**7.** A method of measuring a primary current in a primary conductor, which is magnetically coupled via a ferromagnetic core with a secondary conductor, with the following steps:

> applying a voltage of a predetermined amplitude to the secondary conductor so that a secondary current flows for reversal of the magnetization of the ferromagnetic core;
> measuring the secondary current during the reversal of the magnetization of the core in order to produce a first measurement value;
> reversing the polarity of the voltage so that a secondary current for the further reversal of the magnetization of the ferromagnetic core flows;
> measuring the secondary current during the reversal of the magnetization of the core in order to produce a second measurement value;
> calculating the primary current in dependence on the first and the second measurement values,
> **characterised in that** the reversal of the polarity of the voltage occurs regularly with a predetermined sensor frequency and the sensor frequency is continuously varied.

**8.** A method as claimed in Claim 7, in which the sensor frequency is varied stochastically.

**9.** A method as claimed in Claim 7, in which the sensor frequency is varied in accordance with a predetermined frequency pattern.

10. A method as claimed in Claim 7, in which the primary current includes signal components of a predetermined signal frequency and in which the sensor frequency is varied in dependence on the signal frequency so that the sensor frequency or a whole number multiple thereof differs from the signal frequency.

11. A method as claimed in one of Claims 7 to 10, in which the amplitude of the voltage is varied, whereby the sensor frequency is varied.

12. A method as claimed in Claim 11, in which the amplitude of the voltage is amplitude modulated so that the sensor frequency is frequency modulated.

13. A method as claimed in one of Claims 7 to 12, in which the time of the reversal of the polarity of the voltage is varied, whereby the sensor frequency is altered.

14. A method as claimed in Claim 13, in which the time of the reversal of the polarity of the voltage is modulated periodically about a mean value.


**Revendications**

1. Dispositif de détection de courant pour mesurer un courant primaire ($I_1$) dans un conducteur primaire comprenant :

   - un noyau ferromagnétique pour le couplage magnétique du conducteur primaire sur un conducteur secondaire,
   - une source de tension (G), commandée, reliée au conducteur secondaire,
   - une installation de commande reliée au conducteur secondaire pour inverser régulièrement l'aimantation du noyau magnétique,

   dispositif dans lequel

   - l'installation de commande comporte une source de tension commandée (G) reliée au conducteur secondaire et conçue pour fournir une tension périodique bipolaire ($\pm U$) d'une certaine amplitude de façon à produire un courant secondaire ($I_2$), périodique, résultant, qui produit une inversion d'aimantation périodique correspondant à la fréquence du capteur dans le noyau ferromagnétique et une installation de commande pour commander la source de tension,

   dispositif **caractérisé en ce que**
   l'installation de commande est conçue pour faire varier la fréquence du détecteur pendant le fonctionnement du dispositif de détection.

2. Dispositif de détection de courant selon la revendication 1,
   dans lequel
   l'installation de commande est conçue pour faire varier la fréquence de détection de manière stochastique.

3. Dispositif de détection de courant selon la revendication 1,
   dans lequel
   l'installation de commande est conçue pour faire varier la fréquence de détection selon un motif de fréquence, déterminé.

4. Dispositif de détection de courant selon la revendication 1,
   dans lequel

   - les composantes du signal correspondant au courant primaire, ont une certaine fréquence de signal, et
   - l'installation de commande est conçue pour faire varier la fréquence de détection selon la fréquence de signal de façon que la fréquence de détection ou un multiple entier de celle-ci, diffère de la fréquence de signal.

5. Dispositif de détection de courant selon l'une des revendications 1 à 4,
   dans lequel

l'installation de commande est conçue pour faire varier l'amplitude de la tension de la source de tension pour varier ainsi la fréquence de détection.

**6.** Dispositif de détection de courant selon l'une des revendications 1 à 5,
dans lequel
l'installation de commande est conçue pour faire varier l'instant de l'inversion de polarité de la source de tension pour varier ainsi la fréquence de détection.

**7.** Procédé de mesure d'un courant primaire dans un conducteur primaire couplé magnétiquement à un conducteur secondaire par un noyau ferromagnétique selon les étapes suivantes :

- appliquer une tension d'une certaine amplitude au conducteur secondaire pour faire passer un courant secondaire d'inversion d'aimantation dans le noyau ferromagnétique,
- mesurer le courant secondaire pendant l'inversion d'aimantation du noyau et obtenir une première valeur de mesure,
- inverser la polarité de la tension pour qu'un courant secondaire passe et inverse de nouveau l'aimantation du noyau magnétique,
- mesurer le courant secondaire pendant l'inversion d'aimantation du noyau pour obtenir une seconde valeur de mesure,
- calculer le courant primaire en fonction de la première et de la seconde valeur de mesure,

dispositif **caractérisé en ce qu'**

- on effectue l'inversion de polarité de la tension régulièrement selon une fréquence de détection déterminée et on fait varier en continu la fréquence de détection.

**8.** Procédé selon la revendication 7,
selon lequel
on fait varier la fréquence de détection de manière stochastique.

**9.** Procédé selon la revendication 7,
selon lequel
on fait varier la fréquence de détection selon un motif de fréquence déterminé.

**10.** Procédé selon la revendication 7,
selon lequel

- le courant primaire comporte des composantes de signal d'une fréquence de signal déterminée, et
- la fréquence de détection varie en fonction de la fréquence de signal pour que la fréquence de détection ou un multiple entier de celle-ci, diffère de la fréquence de signal.

**11.** Procédé selon l'une des revendications 7 à 10,
selon lequel
on fait varier l'amplitude de la tension pour faire varier ainsi la fréquence de détection.

**12.** Procédé selon la revendication 11,
selon lequel
on module en amplitude, l'amplitude de la tension pour moduler en fréquence, la fréquence de détection.

**13.** Procédé selon l'une des revendications 7 à 12,
selon lequel
on fait varier l'instant de l'inversion de polarité de la tension pour faire varier la fréquence de détection.

**14.** Procédé selon la revendication 13,
selon lequel
on module l'instant de l'inversion de polarité de la tension de manière périodique autour d'une valeur moyenne.

Primärstrom $i_P$    Primär-
                     wicklung 1

                                    Sekundär-
                                    strom $i_s$

ferromagne-                ü = 1:N
tischer Kern 10

Sekundärwicklung 2
            $u_i$
                                    $\pm U_s$

                    $R_{SH}$                              CTR

                    $u_{SH}$

                                    Q

                                    Mess- und Steuereinheit 20

# FIG. 1

FIG. 2a

FIG. 2b

Magnetisierung M

Sättigungsmagnetisierung $M_{SAT}$

mag. Feldstärke H
$= N \cdot i_S / I_{FE}$

$i_P / I_{FE}$

# FIG. 3a

Sekundärstrom $i_S$    Umpolen    Umpolen

$i_P/N + i_\mu$

$i_P/N - i_\mu$

$+i_{SMAX}$

$i_P/N$

Zeit t

$-i_{SMAX}$

$1/f_{SENSOR}$

positive    negative
Sättigung    Sättigung

# FIG. 3b

FIG. 4a

Sekundärstrom $i_S$

abtasten   abtasten   abtasten   abtasten   abtasten

$i_P/N$

Zeit t

Primärstrom $i_P$

51   50   Störpulse 50

$i_P/N$

Zeit t

Sensor Output

$i_P/N$

Zeit t

blinder Bereich 53

# FIG. 4b

Magnetisierung M

Sättigungsmagnetisierung $M_{SAT}$

mag. Feldstärke H
$= N \cdot i_S / l_{FE}$

$\Delta M$

Koerzitivfeldstärke $H_C$

## FIG. 5a

Sekundärstrom $i_S$

Umpolen Umpolen

abtasten

abtasten

lagnetisierungsstrom $i_\mu$

$-i_\mu$

Zeit t

$-i_{SMAX}$

$\Delta t_+$

$1/f_{SENSOR}$

negative
Sättigung

## FIG. 5b

## FIG. 6

**IN DER BESCHREIBUNG AUFGEFÜHRTE DOKUMENTE**

**In der Beschreibung aufgeführte Patentdokumente**

- DE 4229948

- DE 3611683